# EUROPEAN PATENT APPLICATION

(11) **EP 4 521 900 A1**
(43) Date of publication of application: **12.03.2025**
(21) Application number: 24198679.3
(22) Date of filing: 05.09.2024
(51) Int. Cl.: H10K 59/122, H10K 59/80

(54) **DISPLAY DEVICE AND MANUFACTURING METHOD THEREOF**

(30) Priority: 11.09.2023 JP 2023147023
(71) Applicant: Japan Display Inc., Tokyo 105-0003 (JP)
(72) Inventor: FUKUDA, Kaichi, Tokyo, 105-0003 (JP)
(74) Representative: MERH-IP Matias Erny Reichl Hoffmann Patentanwälte PartG mbB

(57) **Abstract**

According to one embodiment, a display device (DSP) includes an organic insulating layer (12) in a display area (DA) and a surrounding area (SA), a lower electrode (LE1, LE2, LE3) above the organic insulating layer (12) in the display area (DA), a rib layer (5) having a pixel aperture (AP1, AP2, AP3), a first partition (6A) in the display area (DA), a second partition (6B) in the surrounding area (SA), an organic layer (OR1, OR2, OR3), an upper electrode (UE1, UE2, UE3), a sealing layer (SE11, SE12, SE13) covering a stacked film (FL1, FL2, FL3) including the organic layer (OR1, OR2, OR3) and the upper electrode (UE1, UE2, UE3), and a resin layer (RS1) covering the sealing layer (SE11, SE12, SE13). Each of the first and second partitions (6A, 6B) includes a lower portion (61) and an upper portion (62). The resin layer (RS1) directly covers the rib layer (5) and the second partition (6B) in at least part of the surrounding area (SA).

## Description

### FIELD

Embodiments described herein relate generally to a display device and a manufacturing method thereof.

### BACKGROUND

Recently, display devices to which an organic light emitting diode (OLED) is applied as a display element have been put into practical use. In this type of display devices, a technique which can improve the yield is required.

### BRIEF DESCRIPTION OF THE DRAWINGS

FIG. 1 is a diagram showing a configuration example of a display device according to a first embodiment.
FIG. 2 is a schematic plan view showing an example of the layout of subpixels according to the first embodiment.
FIG. 3 is a schematic cross-sectional view of the display device along the III-III line of FIG. 2.
FIG. 4 is a diagram showing an example of a layer structure which could be applied to each organic layer.
FIG. 5 is a schematic plan view of the display device according to the first embodiment.
FIG. 6 is a schematic cross-sectional view of the display device along the VI-VI line of FIG. 5.
FIG. 7 is a schematic cross-sectional view of the display device along the VII-VII line of FIG. 5.
FIG. 8A is a schematic cross-sectional view of the display area of the display device manufactured by the manufacturing method of the first embodiment.
FIG. 8B is a schematic cross-sectional view of the surrounding area of the display device manufactured by the manufacturing method of the first embodiment.
FIG. 9A is a schematic cross-sectional view of the display area and shows a manufacturing process following FIG. 8A.
FIG. 9B is a schematic cross-sectional view of the surrounding area and shows a manufacturing process following FIG. 8B.
FIG. 10A is a schematic cross-sectional view of the display area and shows a manufacturing process following FIG. 9A.
FIG. 10B is a schematic cross-sectional view of the surrounding area and shows a manufacturing process following FIG. 9B.
FIG. 11A is a schematic cross-sectional view of the display area and shows a manufacturing process following FIG. 10A.
FIG. 11B is a schematic cross-sectional view of the surrounding area and shows a manufacturing process following FIG. 10B.
FIG. 12A is a schematic cross-sectional view of the display area and shows a manufacturing process following FIG. 11A.
FIG. 12B is a schematic cross-sectional view of the surrounding area and shows a manufacturing process following FIG. 11B.
FIG. 13A is a schematic cross-sectional view of the display area and shows a manufacturing process following FIG. 12A.
FIG. 13B is a schematic cross-sectional view of the surrounding area and shows a manufacturing process following FIG. 12B.
FIG. 14A is a schematic cross-sectional view of the display area and shows a manufacturing process following FIG. 13A.
FIG. 14B is a schematic cross-sectional view of the surrounding area and shows a manufacturing process following FIG. 13B.
FIG. 15A is a schematic cross-sectional view of the display area and shows a manufacturing process following FIG. 14A.
FIG. 15B is a schematic cross-sectional view of the surrounding area and shows a manufacturing process following FIG. 14B.
FIG. 16A is a schematic cross-sectional view of the display area and shows a manufacturing process following FIG. 15A.
FIG. 16B is a schematic cross-sectional view of the surrounding area and shows a manufacturing process following FIG. 15B.
FIG. 17 is a schematic cross-sectional view of the surrounding area of a display device according to a second embodiment.
FIG. 18 is a schematic cross-sectional view showing the manufacturing process of the display device according to the second embodiment.
FIG. 19 is a schematic cross-sectional view of the surrounding area and shows a manufacturing process following FIG. 18.
FIG. 20 is a schematic cross-sectional view of the surrounding area and shows a manufacturing process following FIG. 19.
FIG. 21 is a schematic cross-sectional view showing an example of the surrounding area of a display device according to a third embodiment.
FIG. 22 is a schematic cross-sectional view showing an example of the surrounding area of the display device according to the third embodiment in a manner similar to that of FIG. 21.
FIG. 23 is a schematic cross-sectional view showing another example of the surrounding area of the display device according to the third embodiment.

### DETAILED DESCRIPTION

In general, according to one embodiment, a display device comprises an organic insulating layer provided in a display area which displays an image and a surrounding area around the display area, a lower electrode provided above the organic insulating layer in the display area, a rib layer provided in the display area and the surrounding area and having a pixel aperture which overlaps the lower electrode, a first partition provided above the rib layer in the display area, a second partition provided above the rib layer in the surrounding area, an organic layer which is in contact with the lower electrode through the pixel aperture and emits light based on application of voltage, an upper electrode which covers the organic layer and is in contact with the first partition, a sealing layer which covers a stacked film including the organic layer and the upper electrode, and a resin layer which is provided in the display area and the surrounding area and covers the sealing layer. Each of the first partition and the second partition includes a lower portion provided above the rib layer and an upper portion having an end portion which protrudes from a side surface of the lower portion. The resin layer directly covers the rib layer and the second partition in at least part of the surrounding area.

According to another embodiment, a display device comprises an organic insulating layer provided in a display area which displays an image and a surrounding area around the display area, a first lower electrode, a second lower electrode and a third lower electrode provided above the organic insulating layer in the display area, a rib layer provided in the display area and the surrounding area and having a first pixel aperture, a second pixel aperture and a third pixel aperture overlapping the first lower electrode, the second lower electrode and the third lower electrode, respectively, a first partition provided above the rib layer in the display area, a second partition provided above the rib layer in the surrounding area, a first organic layer, a second organic layer and a third organic layer which are in contact with the first lower electrode, the second lower electrode and the third lower electrode through the first pixel aperture, the second pixel aperture and the third pixel aperture, respectively, and emit light based on application of voltage, a first upper electrode, a second upper electrode and a third upper electrode which cover the first organic layer, the second organic layer and the third organic layer, respectively, and are in contact with the first partition, a first sealing layer which covers a first stacked film including the first organic layer and the first upper electrode, a second sealing layer which covers a second stacked film including the second organic layer and the second upper electrode, and a third sealing layer which covers a third stacked film including the third organic layer and the third upper electrode. Each of the first partition and the second partition includes a lower portion provided above the rib layer and an upper portion having an end portion which protrudes from a side surface of the lower portion. A wavelength of light emitted from the third organic layer is longer than wavelengths of light emitted from the first organic layer and the second organic layer. The third stacked film and the third sealing layer are provided in at least part of the surrounding area.

According to yet another embodiment, a manufacturing method of a display device includes forming an organic insulating layer in a display area which displays an image and a surrounding area around the display area, forming a first lower electrode, a second lower electrode and a third lower electrode above the organic insulating layer in the display area, forming a rib layer which covers the first lower electrode, the second lower electrode and the third lower electrode in the display area and the surrounding area, forming a first partition including a lower portion provided above the rib layer and an upper portion having an end portion which protrudes from a side surface of the lower portion in the display area, forming a second partition including the lower portion and the upper portion in the surrounding area, forming a first pixel aperture, a second pixel aperture and a third pixel aperture which overlap the first lower electrode, the second lower electrode and the third lower electrode, respectively, in the rib layer before or after forming the first partition and the second partition, forming a first stacked film including a first organic layer which emits light based on application of voltage and a first upper electrode which is in contact with the lower portion in the display area and the surrounding area, forming a first sealing layer which covers the first stacked film, of the first stacked film and the first sealing layer, leaving portions located above the first lower electrode, and eliminating other portions in the display area and portions located in the surrounding area, forming a second stacked film including a second organic layer which emits light based on application of voltage and a second upper electrode which is in contact with the lower portion in the display area and the surrounding area, forming a second sealing layer which covers the second stacked film, of the second stacked film and the second sealing layer, leaving portions located above the second lower electrode, and eliminating other portions in the display area and portions located in the surrounding area, forming a third stacked film including a third organic layer which emits light based on application of voltage and a third upper electrode which is in contact with the lower portion in the display area and the surrounding area, and forming a third sealing layer which covers the third stacked film.

Each embodiment can improve the yield of a display device.

Embodiments will be described with reference to the accompanying drawings.

The disclosure is merely an example, and proper changes in keeping with the spirit of the invention, which are easily conceivable by a person of ordinary skill in the art, come within the scope of the invention as a matter of course. In addition, in some cases, in order to make the description clearer, the widths, thicknesses, shapes, etc., of the respective parts are illustrated schematically in the drawings, rather than as an accurate representation of what is implemented. However, such schematic illustration is merely exemplary, and in no way restricts the interpretation of the invention. In addition, in the specification and drawings, structural elements which function in the same or a similar manner to those described in connection with preceding drawings are denoted by like reference numbers, detailed description thereof being omitted unless necessary.

In the drawings, in order to facilitate understanding, an X-axis, a Y-axis and a Z-axis orthogonal to each other are shown depending on the need. A direction parallel to the X-axis is referred to as an X-direction. A direction parallel to the Y-axis is referred to as a Y-direction. A direction parallel to the Z-axis is referred to as a Z-direction. The Z-direction is the normal direction of a plane including the X-direction and the Y-direction. When various elements are viewed parallel to the Z-direction, the appearance is defined as a plan view.

The display device of each embodiment is an organic electroluminescent display device comprising an organic light emitting diode (OLED) as a display element, and could be mounted on various types of electronic devices such as a television, a personal computer, a vehicle-mounted device, a tablet, a smartphone, a mobile phone and a wearable terminal.

### [First Embodiment]

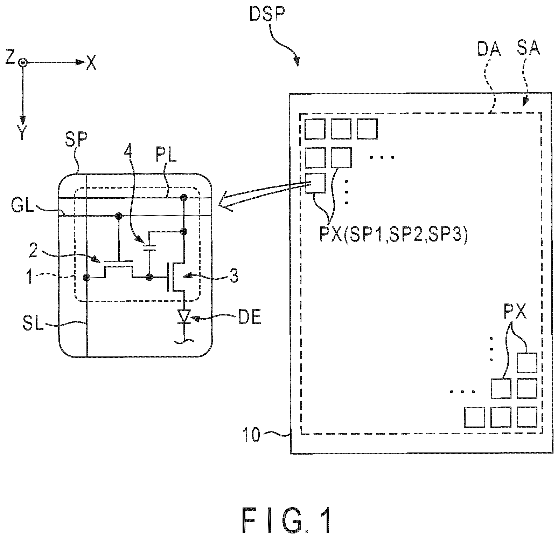

FIG. 1 is a diagram showing a configuration example of a display device DSP according to a first embodiment. The display device DSP comprises an insulating substrate 10. The substrate 10 has a display area DA which displays an image, and a surrounding area SA around the display area DA. The substrate 10 may be glass or a resinous film having flexibility.

In the embodiment, the substrate 10 is rectangular as seen in plan view. It should be noted that the shape of the substrate 10 in plan view is not limited to a rectangle and may be another shape such as a square, a circle or an oval.

The display area DA comprises a plurality of pixels PX arrayed in matrix in an X-direction and a Y-direction. Each pixel includes a plurality of subpixels SP which display different colors. This embodiment assumes a case where each pixel PX includes a blue subpixel SP1, a green subpixel SP2 and a red subpixel SP3. However, each pixel PX may include a subpixel SP which exhibits another color such as white in addition to subpixels SP1, SP2 and SP3 or instead of one of subpixels SP1, SP2 and SP3.

Each subpixel SP comprises a pixel circuit 1 and a display element DE driven by the pixel circuit 1. The pixel circuit 1 comprises a pixel switch 2, a drive transistor 3 and a capacitor 4. Each of the pixel switch 2 and the drive transistor 3 is, for example, a switching element consisting of a thin-film transistor.

A plurality of scanning lines GL which supply scanning signals to the pixel circuits 1 of subpixels SP, a plurality of signal lines SL which supply video signals to the pixel circuits 1 of subpixels SP and a plurality of power lines PL are provided in the display area DA. In the example of FIG. 1, the scanning lines GL and the power lines PL extend in the X-direction, and the signal lines SL extend in the Y-direction.

The gate electrode of the pixel switch 2 is connected to the scanning line GL. The source electrode of the pixel switch 2 is connected to the signal line SL. The drain electrode of the pixel switch 2 is connected to the gate electrode of the drive transistor 3 and the capacitor 4. The source electrode of the drive transistor 3 is connected to the power line PL and the capacitor 4. The drain electrode of the drive transistor 3 is connected to the display element DE.

It should be noted that the configuration of the pixel circuit 1 is not limited to the example shown in the figure. For example, the pixel circuit 1 may comprise more thin-film transistors and capacitors.

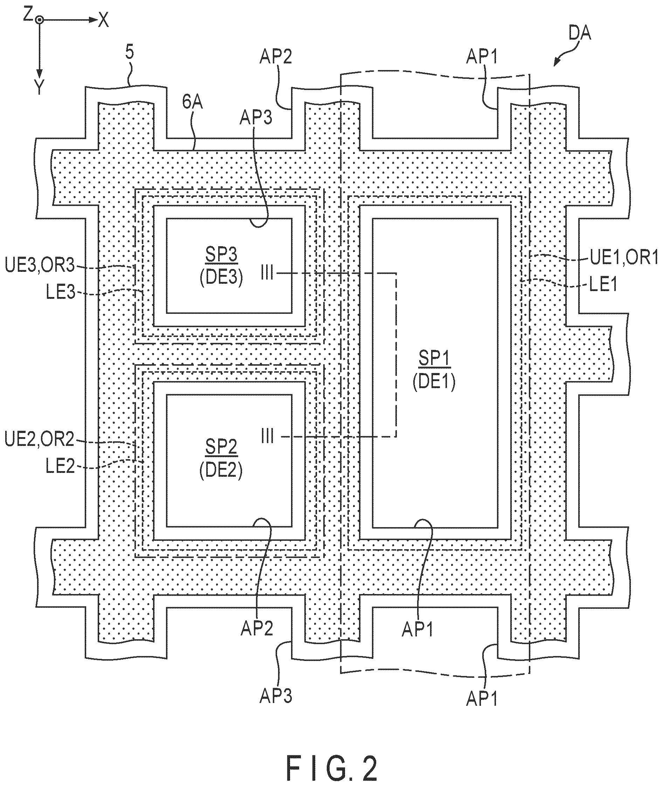

FIG. 2 is a schematic plan view showing an example of the layout of subpixels SP1, SP2 and SP3. In the example of FIG. 2, each of subpixels SP2 and SP3 is adjacent to subpixel SP1 in the X-direction. Further, subpixels SP2 and SP3 are arranged in the Y-direction.

When subpixels SP1, SP2 and SP3 are provided in line with this layout, a column in which subpixels SP2 and SP3 are alternately provided in the Y-direction and a column in which a plurality of subpixels SP1 are repeatedly provided in the Y-direction are formed in the display area DA. These columns are alternately arranged in the X-direction. It should be noted that the layout of subpixels SP1, SP2 and SP3 is not limited to the example of FIG. 2.

A rib layer 5 is provided in the display area DA. The rib layer 5 has pixel apertures (first to third pixel apertures) AP1, AP2 and AP3 in subpixels SP1, SP2 and SP3, respectively. In the example of FIG. 2, the pixel aperture AP1 is larger than the pixel aperture AP2. The pixel aperture AP2 is larger than the pixel aperture AP3. Thus, among subpixels SP1, SP2 and SP3, the aperture ratio of subpixel SP1 is the greatest, and the aperture ratio of subpixel SP3 is the least. It should be noted that the size of the pixel aperture AP1, AP2 or AP3 is not limited to this example. For example, the sizes of the pixel apertures AP2 and AP3 may be equal to each other.

Subpixel SP1 comprises a lower electrode (first lower electrode) LE1, an upper electrode (first upper electrode) UE1 and an organic layer (first organic layer) OR1 overlapping the pixel aperture AP1. Subpixel SP2 comprises a lower electrode (second lower electrode) LE2, an upper electrode (second upper electrode) UE2 and an organic layer (second organic layer) OR2 overlapping the pixel aperture AP2. Subpixel SP3 comprises a lower electrode (third lower electrode) LE3, an upper electrode (third upper electrode) UE3 and an organic layer (third organic layer) OR3 overlapping the pixel aperture AP3.

Of the lower electrode LE1, the upper electrode UE1 and the organic layer OR1, the portions which overlap the pixel aperture AP1 constitute the display element DE1 of subpixel SP1. Of the lower electrode LE2, the upper electrode UE2 and the organic layer OR2, the portions which overlap the pixel aperture AP2 constitute the display element DE2 of subpixel SP2. Of the lower electrode LE3, the upper electrode UE3 and the organic layer OR3, the portions which overlap the pixel aperture AP3 constitute the display element DE3 of subpixel SP3. Each of the display elements DE1, DE2 and DE3 may further include a cap layer as described later. The rib layer 5 surrounds each of these display elements DE1, DE2 and DE3.

A partition (first partition) 6A is provided in the display area DA. The partition 6A is located above the rib layer 5 and overlaps the rib layer 5 as a whole. In the example of FIG. 2, the partition 6A has a planar shape similar to that of the rib layer 5. In other words, the partition 6A has an aperture in each of subpixels SP1, SP2 and SP3. From another viewpoint, the rib layer 5 and the partition 6A have grating shapes as seen in plan view and surround each of the display elements DE1, DE2 and DE3. The partition 6A functions as lines which apply common voltage to the upper electrodes UE1, UE2 and UE3.

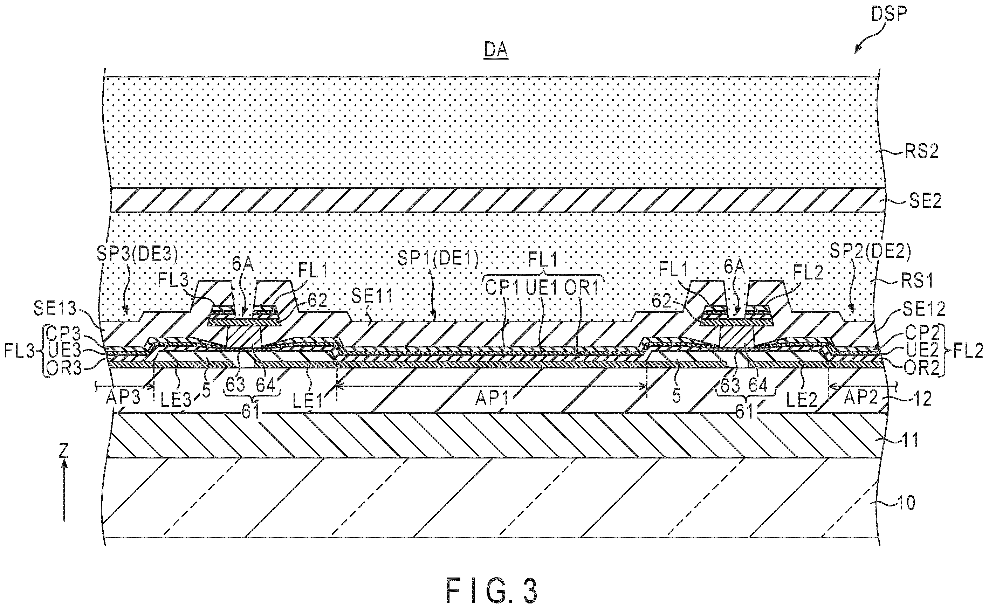

FIG. 3 is a schematic cross-sectional view of the display device DSP along the III-III line of FIG. 2. A circuit layer 11 is provided on the substrate 10 described above. The circuit layer 11 includes various circuits and lines such as the pixel circuits 1, scanning lines GL, signal lines SL and power lines PL shown in FIG. 1. The circuit layer 11 is covered with an organic insulating layer 12. The organic insulating layer 12 functions as a planarization film which planarizes the irregularities formed by the circuit layer 11.

The lower electrodes LE1, LE2 and LE3 are provided on the organic insulating layer 12. The rib layer 5 is provided on the organic insulating layer 12 and the lower electrodes LE1, LE2 and LE3. The end portions of the lower electrodes LE1, LE2 and LE3 are covered with the rib layer 5. Although not shown in the section of FIG. 3, the lower electrodes LE1, LE2 and LE3 are connected to the respective pixel circuits 1 (the drain electrodes of the drive transistors 3 shown in FIG. 1) of the circuit layer 11 through respective contact holes provided in the organic insulating layer 12.

The partition 6A includes a conductive lower portion 61 provided on the rib layer 5 and an upper portion 62 provided on the lower portion 61. The upper portion 62 has a width greater than that of the lower portion 61. By this configuration, the both end portions of the upper portion 62 protrude relative to the side surfaces of the lower portion 61. This shape of the partition 6A is called an overhang shape.

In the example of FIG. 3, the lower portion 61 has a bottom layer 63 and a stem layer 64. The bottom layer 63 is located between the stem layer 64 and the rib layer 5 and is formed so as to be thinner than the stem layer 64. In the example of FIG. 3, the both end portions of the bottom layer 63 protrude from the side surfaces of the stem layer 64.

The organic layer OR1 covers the lower electrode LE1 through the pixel aperture AP1. The upper electrode UE1 covers the organic layer OR1 and faces the lower electrode LE1. The organic layer OR2 covers the lower electrode LE2 through the pixel aperture AP2. The upper electrode UE2 covers the organic layer OR2 and faces the lower electrode LE2. The organic layer OR3 covers the lower electrode LE3 through the pixel aperture AP3. The upper electrode UE3 covers the organic layer OR3 and faces the lower electrode LE3. The upper electrodes UE1, UE2 and UE3 are in contact with the side surfaces of the lower portions 61 of the partitions 6A.

The display element DE1 includes a cap layer CP1 which covers the upper electrode UE1. The display element DE2 includes a cap layer CP2 which covers the upper electrode UE2. The display element DE3 includes a cap layer CP3 which covers the upper electrode UE3. The cap layers CP1, CP2 and CP3 function as optical adjustment layers which improve the extraction efficiency of the light emitted from the organic layers OR1, OR2 and OR3, respectively.

In the following explanation, a multilayer body including the organic layer OR1, the upper electrode UE1 and the cap layer CP1 is called a stacked film (first stacked film) FL1. A multilayer body including the organic layer OR2, the upper electrode UE2 and the cap layer CP2 is called a stacked film (second stacked film) FL2. A multilayer body including the organic layer OR3, the upper electrode UE3 and the cap layer CP3 is called a stacked film (third stacked film) FL3.

The stacked film FL1 is partly located on the upper portion 62. This portion is spaced apart from, of the stacked film FL1, the portion located around the partition 6A (in other words, the portion which constitutes the display element DE1). Similarly, the stacked film FL2 is partly located on the upper portion 62. This portion is spaced apart from, of the stacked film FL2, the portion located around the partition 6A (in other words, the portion which constitutes the display element DE2). Further, the stacked film FL3 is partly located on the upper portion 62. This portion is spaced apart from, of the stacked film FL3, the portion located around the partition 6A (in other words, the portion which constitutes the display element DE3).

Sealing layers (first to third sealing layers) SE11, SE12 and SE13 which cover the stacked films FL1, FL2 and FL3, respectively, are provided in subpixels SP1, SP2 and SP3, respectively. Specifically, the sealing layer SE11 continuously covers the cap layer CP1 and the partition 6A around subpixel SP1. The sealing layer SE12 continuously covers the cap layer CP2 and the partition 6A around subpixel SP2. The sealing layer SE13 continuously covers the cap layer CP3 and the partition 6A around subpixel SP3.

In the example of FIG. 3, the stacked film FL1 and sealing layer SE11 located on the partition 6A between subpixels SP1 and SP2 are spaced apart from the stacked film FL2 and sealing layer SE12 located on this partition 6A. The stacked film FL1 and sealing layer SE11 located on the partition 6A between subpixels SP1 and SP3 are spaced apart from the stacked film FL3 and sealing layer SE13 located on this partition 6A.

The sealing layers SE11, SE12 and SE13 are covered with a resin layer RS1. The resin layer RS1 is covered with a sealing layer SE2. The sealing layer SE2 is covered with a resin layer RS2. The resin layers RS1 and RS2 and the sealing layer SE2 are continuously provided in at least the entire display area DA and partly extend in the surrounding area SA as well.

A cover member such as a polarizer, a protective film or a cover glass may be further provided above the resin layer RS2. This cover member may be attached to the resin layer RS2 via, for example, an adhesive layer such as an optical clear adhesive (OCA).

The organic insulating layer 12 is formed of an organic insulating material such as polyimide. Each of the rib layer 5 and the sealing layers SE11, SE12, SE13 and SE2 is formed of an inorganic insulating material such as silicon nitride (SiNx), silicon oxide (SiOx) or silicon oxynitride (SiON). For example, the rib layer 5 is formed of silicon oxynitride, and each of the sealing layers SE11, SE12, SE13 and SE2 is formed of silicon nitride. Each of the resin layers RS1 and RS2 is formed of, for example, a resinous material (organic insulating material) such as epoxy resin or acrylic resin.

Each of the lower electrodes LE1, LE2 and LE3 has a reflective layer and a pair of conductive oxide layers covering the upper and lower surfaces of the reflective layer. The reflective layer may be formed of, for example, a metal material having excellent light reflectivity, such as silver. Each conductive oxide layer may be formed of, for example, a transparent conductive oxide such as indium tin oxide (ITO), indium zinc oxide (IZO) or indium gallium zinc oxide (IGZO).

Each of the upper electrodes UE1, UE2 and UE3 is formed of, for example, a metal material such as an alloy of magnesium and silver (MgAg). For example, the lower electrodes LE1, LE2 and LE3 correspond to anodes, and the upper electrodes UE1, UE2 and UE3 correspond to cathodes.

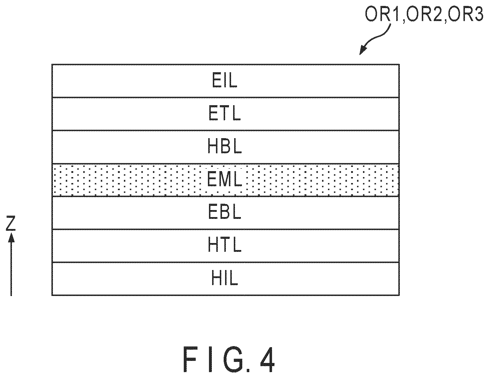

FIG. 4 is a diagram showing an example of a layer structure which could be applied to the organic layers OR1, OR2 and OR3. Each of the organic layers OR1, OR2 and OR3 consists of a plurality of thin films including a light emitting layer EML. This embodiment assumes a case where each of the organic layers OR1, OR2 and OR3 comprises a structure in which a hole injection layer HIL, a hole transport layer HTL, an electron blocking layer EBL, a light emitting layer EML, a hole blocking layer HBL, an electron transport layer ETL and an electron injection layer EIL are stacked in order in a Z-direction. It should be noted that each of the organic layers OR1, OR2 and OR3 may comprise another structure such as a tandem structure including a plurality of light emitting layers EML.

Each of the cap layers CP1, CP2 and CP3 comprises, for example, a stacked structure in which a plurality of transparent layers are stacked. These transparent layers could include a layer formed of an inorganic material and a layer formed of an organic material. The transparent layers have refractive indices different from each other. For example, the refractive indices of these transparent layers are different from the refractive indices of the upper electrodes UE1, UE2 and UE3 and the refractive indices of the sealing layers SE11, SE12 and SE13. It should be noted that at least one of the cap layers CP1, CP2 and CP3 may be omitted.

Each of the bottom layer 63 and stem layer 64 of the partition 6A is formed of, for example, a metal material. For the metal material of the bottom layer 63, for example, molybdenum (Mo), titanium (Ti), titanium nitride (TiN), a molybdenum-tungsten alloy (MoW) or a molybdenum-niobium alloy (MoNb) can be used. For the metal material of the stem layer 64, for example, aluminum (Al), an aluminum-neodymium alloy (AlNd), an aluminum-yttrium alloy (AlY) or an aluminum-silicon alloy (AlSi) can be used. It should be noted that at least one of the bottom layer 63 and the stem layer 64 may comprise a stacked structure consisting of a plurality of layers. The stem layer 64 may include a layer formed of an insulating material.

For example, the upper portion 62 of the partition 6A comprises a stacked structure consisting of a lower layer formed of a metal material and an upper layer formed of conductive oxide. For the metal material forming the lower layer, for example, titanium, titanium nitride, molybdenum, tungsten, a molybdenum-tungsten alloy or a molybdenum-niobium alloy can be used. For the conductive oxide forming the upper layer, for example, ITO or IZO can be used. It should be noted that the upper portion 62 may comprise a single-layer structure of a metal material. The upper portion 62 may further include a layer formed of an insulating material.

Common voltage is applied to the partition 6A. This common voltage is applied to each of the upper electrodes UE1, UE2 and UE3 which are in contact with the side surfaces of the lower portions 61. Pixel voltage is applied to the lower electrodes LE1, LE2 and LE3 through the pixel circuits 1 provided in subpixels SP1, SP2 and SP3, respectively, based on the video signals of the signal lines SL.

The organic layers OR1, OR2 and OR3 emit light based on the application of voltage. Specifically, when a potential difference is formed between the lower electrode LE1 and the upper electrode UE1, the light emitting layer EML of the organic layer OR1 emits light in a blue wavelength range. When a potential difference is formed between the lower electrode LE2 and the upper electrode UE2, the light emitting layer EML of the organic layer OR2 emits light in a green wavelength range. When a potential difference is formed between the lower electrode LE3 and the upper electrode UE3, the light emitting layer EML of the organic layer OR3 emits light in a red wavelength range.

As another example, the light emitting layers EML of the organic layers OR1, OR2 and OR3 may emit light exhibiting the same color (for example, white). In this case, the display device DSP may comprise color filters which convert the light emitted from the light emitting layers EML into light exhibiting colors corresponding to subpixels SP1, SP2 and SP3. The display device DSP may comprise a layer including quantum dots which generate light exhibiting colors corresponding to subpixels SP1, SP2 and SP3 by the excitation caused by the light emitted from the light emitting layers EML.

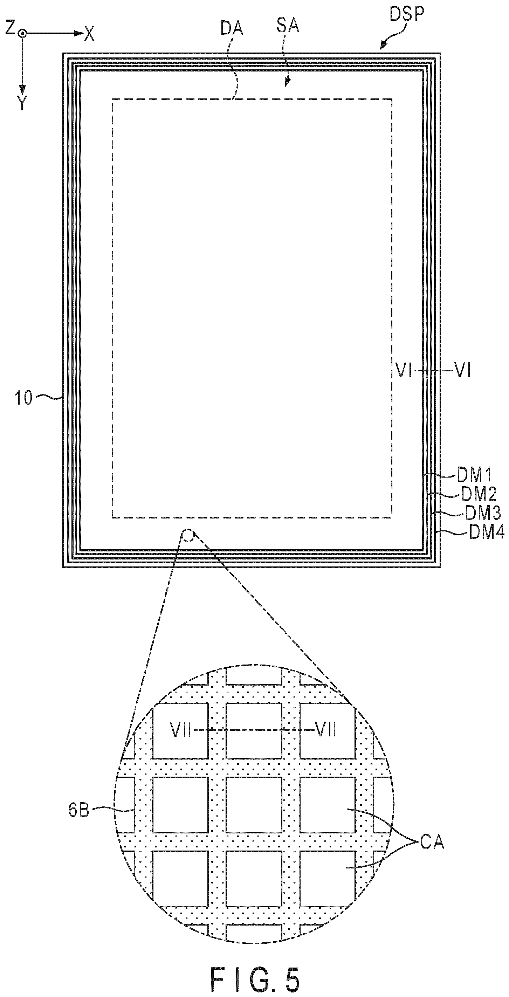

FIG. 5 is a schematic plan view of the display device DSP. The display device DSP comprises dam portions DM1, DM2, DM3 and DM4 provided in the surrounding area SA. All of the dam portions DM1, DM2, DM3 and DM4 surround the display area DA.

As shown in the enlarged view of FIG. 5, a partition (second partition) 6B is provided in the surrounding area SA. For example, the partition 6B has a grating shape as shown in the figure and is provided in an area located between the display area DA and the dam portion DM1. From another viewpoint, the partition 6B forms a plurality of closed areas CA. Each closed area CA is, for example, a square or rectangular area. However, each closed area CA may have another shape.

The shape of the partition 6B is not limited to a grating shape. As another example, in addition to the partition 6B having a grating shape or in place of the partition 6B having a grating shape, a plurality of partitions 6B spaced apart from each other may be provided in the surrounding area SA.

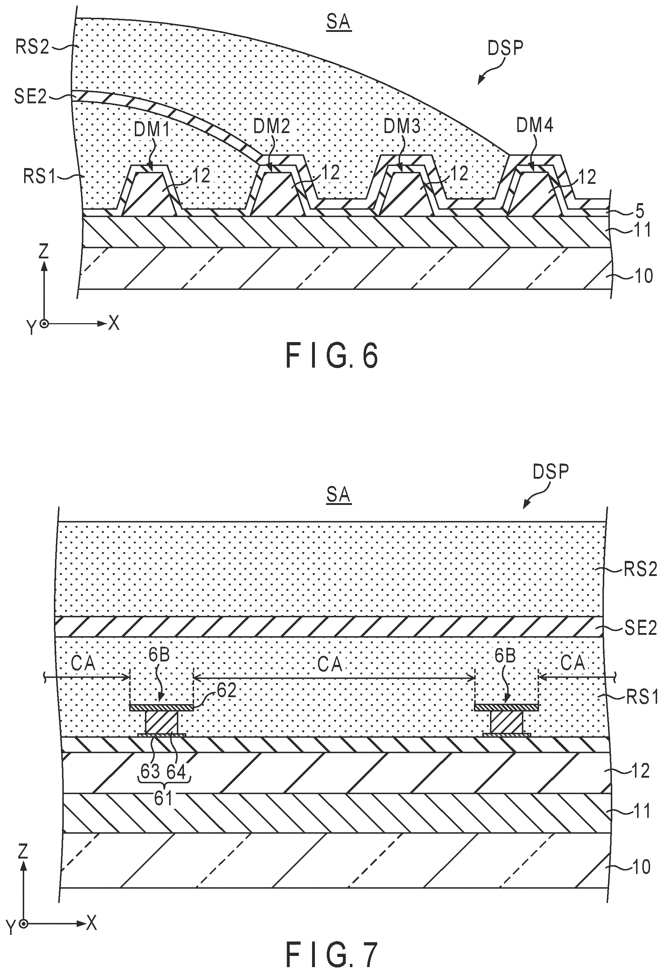

FIG. 6 is a schematic cross-sectional view of the display device DSP along the VI-VI line of FIG. 5. The dam portions DM1, DM2, DM3 and DM4 are formed of, for example, the organic insulating layer 12 and have convex shapes toward the Z-direction.

The rib layer 5, the resin layer RS1, the sealing layer SE2 and the resin layer RS2 are provided in the surrounding area SA as well. In the example of FIG. 6, the dam portions DM1, DM2, DM3 and DM4 are covered with the rib layer 5.

When the display device DSP is manufactured, the dam portions DM1, DM2, DM3 and DM4 function to dam up the resin layers RS1 and RS2 before they are cured. In the example of FIG. 6, the end portion of the resin layer RS1 is located near the dam portion DM2, and the end portion of the resin layer RS2 is located near the dam portion DM4. However, the position of the end portion of the resin layer RS1 or RS2 is not limited to this example.

In the example of FIG. 6, the sealing layer SE2 protrudes from the end portion of the resin layer RS2. The sealing layer SE2 is in contact with the rib layer 5 which covers the dam portions DM2, DM3 and DM4. As another example, the sealing layer SE2 may not protrude from the end portion of the resin layer RS2.

It should be noted that the number of dam portions may not be necessarily four in a manner different from that of FIG. 5 and FIG. 6. In other words, the display device DSP may comprise three or less dam portions or five or more dam portions.

FIG. 7 is a schematic cross-sectional view of the display device DSP along the VII-VII line of FIG. 5. The partition 6B comprises a structure similar to that of the partition 6A. Specifically, the partition 6B comprises a lower portion 61 and an upper portion 62. Further, the lower portion 61 of the partition 6B comprises a bottom layer 63 and a stem layer 64.

The partition 6B is provided on the rib layer 5. In the section of FIG. 7, no aperture is provided in the rib layer 5 of the closed area CA. For example, the partition 6B is connected to the partition 6A. Further, at a position in the surrounding area SA, the partition 6B is connected to the feed line of the circuit layer 11 through a contact hole provided in the rib layer 5. By this configuration, common voltage can be applied to the partition 6A through the partition 6B. As another example, the partition 6B may be electrically floating.

In this embodiment, none of the stacked films FL1, FL2 and FL3 and the sealing layers SE11, SE12 and SE13 is provided in the surrounding area SA. Thus, in the surrounding area SA, the resin layer RS1 directly covers the rib layer 5 and the partition 6B. The area in which the resin layer RS1 directly covers the rib layer 5 and the partition 6B in this manner ranges over, for example, the entire part between the display area DA and the dam portion DM1. However, the range of the area is not limited to this example.

It should be noted that the stacked film FL1 and the sealing layer SE11, the stacked film FL2 and the sealing layer SE12 or the stacked film FL3 and the sealing layer SE13 may be provided in part of the surrounding area SA. Even in this case, to prevent the removal of the stacked films FL1, FL2 and FL3 described later, it is preferable that the stacked film FL1, FL2 or FL3 or the sealing layer SE11, SE12 or SE13 should not be provided in a large part of the surrounding area SA.

Now, this specification explains the manufacturing method of the display device DSP according to the embodiment.

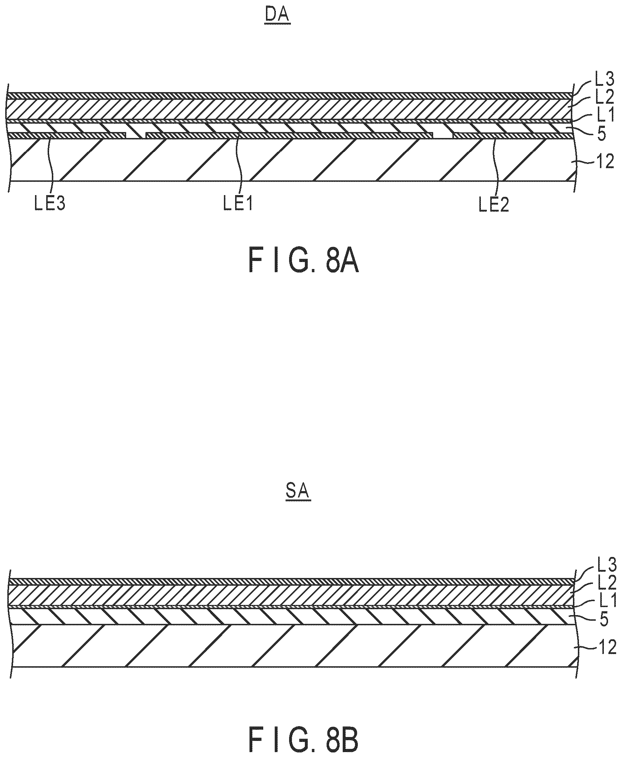

Each of FIG. 8A to FIG. 16A is a schematic cross-sectional view of the display area DA of the display device DSP manufactured by the manufacturing method of the embodiment. Each of FIG. 8B to FIG. 16B is a schematic cross-sectional view of the surrounding area SA of the display device DSP manufactured by the manufacturing method of the embodiment. It should be noted that the substrate 10 and the circuit layer 11 are omitted in FIG. 8A to FIG. 16A and FIG. 8B to FIG. 16B.

To manufacture the display device DSP, first, the circuit layer 11 and the organic insulating layer 12 are formed on the substrate 10. Subsequently, as shown in FIG. 8A, the lower electrodes LE1, LE2 and LE3 are formed on the organic insulating layer 12. Further, the rib layer 5 which covers the lower electrodes LE1, LE2 and LE3, a first layer L1 which covers the rib layer 5, a second layer L2 which covers the first layer L1 and a third layer L3 which covers the second layer L2 are formed in order.

The first layer L1, the second layer L2 and the third layer L3 are layers which should be processed into the bottom layer 63, the stem layer 64 and the upper portion 62, respectively. As shown in FIG. 8B, the rib layer 5, the first layer L1, the second layer L2 and the third layer L3 are formed in the surrounding area SA as well.

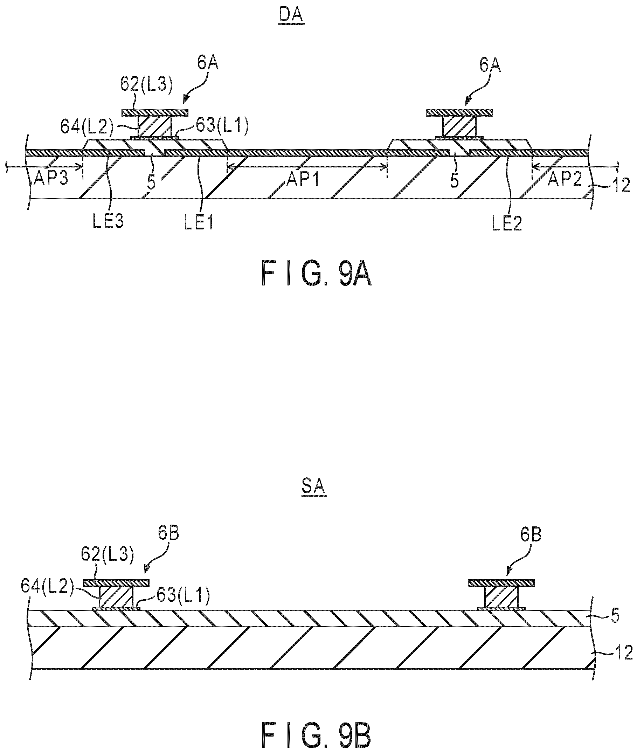

Subsequently, as shown in FIG. 9A and FIG. 9B, the first layer L1, the second layer L2 and the third layer L3 are patterned. This patterning includes etching for processing the third layer L3 into the shapes of the upper portions 62 of the partitions 6A and 6B, etching for processing the second layer L2 into the shapes of the stem layers 64 of the partitions 6A and 6B and etching for processing the first layer L1 into the shapes of the bottom layers 63 of the partitions 6A and 6B. By these etching processes, the partition 6A is formed in the display area DA, and further, the partition 6B is formed in the surrounding area SA.

After the formation of the partitions 6A and 6B, as shown in FIG. 9A, the pixel apertures AP1, AP2 and AP3 are formed in the rib layer 5. As another example, the pixel apertures AP1, AP2 and AP3 may be formed before the formation of the partitions 6A and 6B.

Subsequently, a process for forming the display elements DE1, DE2 and DE3 is performed. In the embodiment, this specification assumes a case where the display element DE1 is formed firstly, and the display element DE2 is formed secondly, and the display element DE3 is formed lastly. It should be noted that the formation order of the display elements DE1, DE2 and DE3 is not limited to this example.

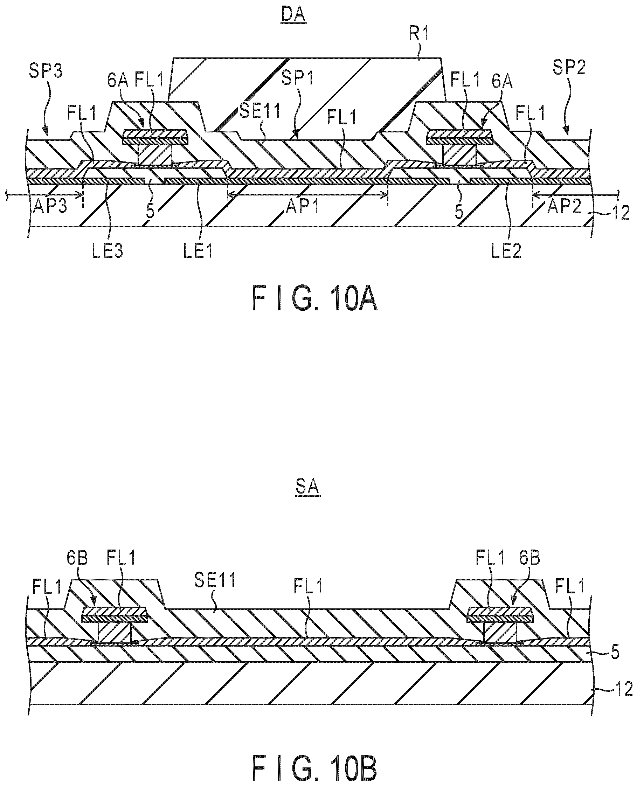

To form the display element DE1, first, as shown in FIG. 10A and FIG. 10B, the stacked film FL1 and the sealing layer SE11 are formed in the entire part of the display area DA and the surrounding area SA. The stacked film FL1 includes, as shown in FIG. 3, the organic layer OR1 which is in contact with the lower electrode LE1 through the pixel aperture AP1, the upper electrode UE1 which covers the organic layer OR1 and the cap layer CP1 which covers the upper electrode UE1. The organic layer OR1, the upper electrode UE1 and the cap layer CP1 are formed by vapor deposition. The sealing layer SE11 is formed by chemical vapor deposition (CVD).

The stacked film FL1 is divided into a plurality of portions by the partitions 6A and 6B having overhang shapes. As shown in FIG. 10A, in the display area DA, the stacked film FL1 covers the lower electrodes LE1, LE2 and LE3 exposed through the pixel apertures AP1, AP2 and AP3, the rib layer 5 and the partition 6A. As shown in FIG. 10B, in the surrounding area SA, the stacked film FL1 covers the rib layer 5 and the partition 6B. The sealing layer SE11 continuously covers the portions into which the stacked film FL1 is divided, and the partitions 6A and 6B.

Subsequently, the stacked film FL1 and the sealing layer SE11 are patterned. In this patterning, as shown in FIG. 10A, a resist R1 is provided on the sealing layer SE11. The resist R1 covers subpixel SP1 and part of the partition 6A around the subpixel. The resist R1 is not provided in the surrounding area SA.

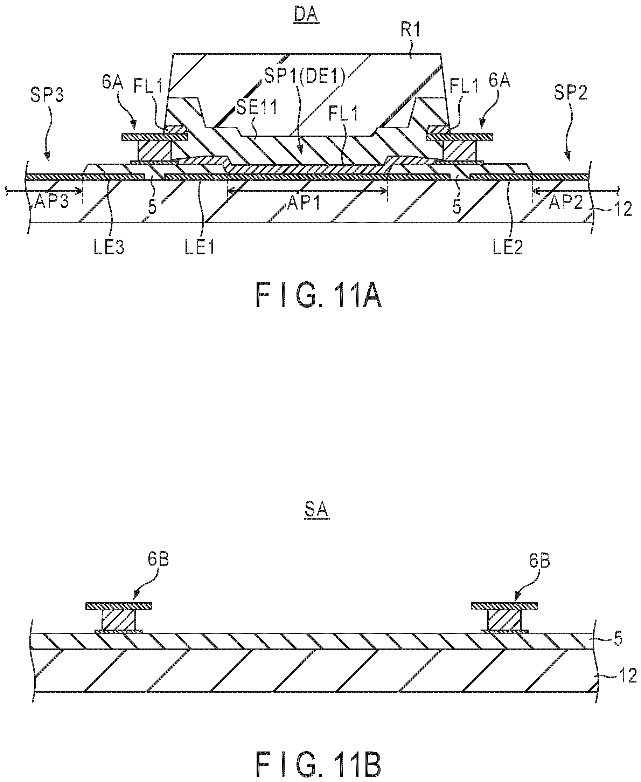

Subsequently, as shown in FIG. 11A and FIG. 11B, the portions of the stacked film FL1 and the sealing layer SE11 exposed from the resist R1 are removed by etching using the resist R1 as a mask. In other words, of the stacked film FL1 and the sealing layer SE11, the portions located above the lower electrode LE1 remain, and the other portions in the display area DA and the portions located in the surrounding area SA are removed. By this process, the display element DE1 is formed in subpixel SP1. For example, this etching includes wet etching and dry etching processes which are performed in order for the sealing layer SE11, the cap layer CP1, the upper electrode UE1 and the organic layer OR1. After this etching, the resist R1 is removed.

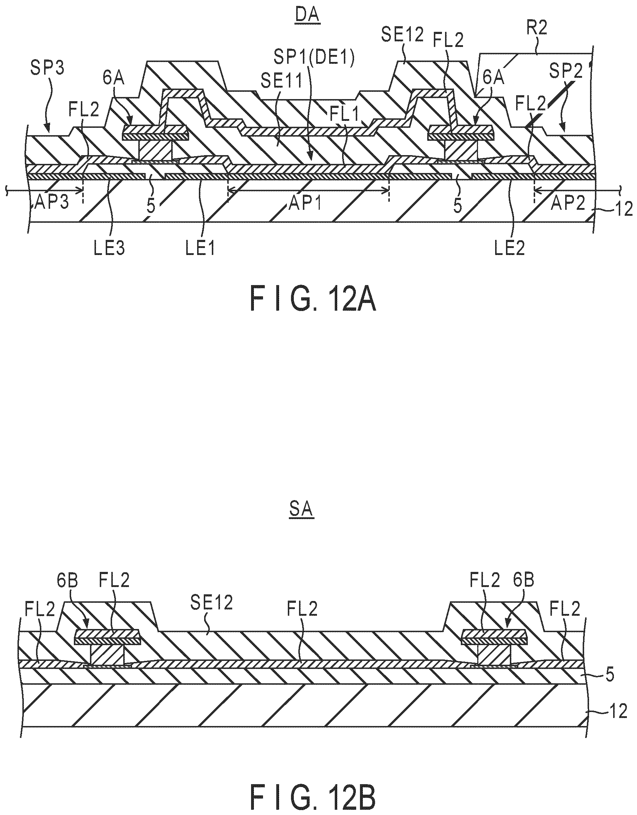

The display element DE2 is formed by a procedure similar to that of the display element DE1. In other words, to form the display element DE2, first, as shown in FIG. 12A and FIG. 12B, the stacked film FL2 and the sealing layer SE12 are formed in the entire part of the display area DA and the surrounding area SA. The stacked film FL2 includes, as shown in FIG. 3, the organic layer OR2 which is in contact with the lower electrode LE2 through the pixel aperture AP2, the upper electrode UE2 which covers the organic layer OR2 and the cap layer CP2 which covers the upper electrode UE2. The organic layer OR2, the upper electrode UE2 and the cap layer CP2 are formed by vapor deposition. The sealing layer SE12 is formed by CVD.

Subsequently, the stacked film FL2 and the sealing layer SE12 are patterned. In this patterning, as shown in FIG. 12A, a resist R2 is provided on the sealing layer SE12. The resist R2 covers subpixel SP2 and part of the partition 6A around the subpixel. The resist R2 is not provided in the surrounding area SA.

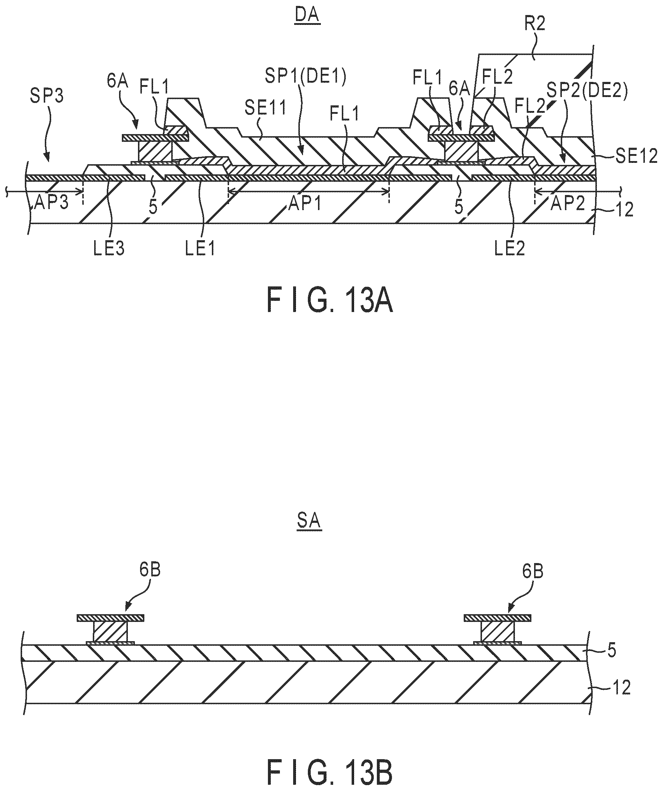

Subsequently, as shown in FIG. 13A and FIG. 13B, the portions of the stacked film FL2 and the sealing layer SE12 exposed from the resist R2 are removed by etching using the resist R2 as a mask. In other words, of the stacked film FL2 and the sealing layer SE12, the portions located above the lower electrode LE2 remain, and the other portions in the display area DA and the portions located in the surrounding area SA are removed. By this process, the display element DE2 is formed in subpixel SP2. For example, this etching includes wet etching and dry etching processes which are performed in order for the sealing layer SE12, the cap layer CP2, the upper electrode UE2 and the organic layer OR2. After this etching, the resist R2 is removed.

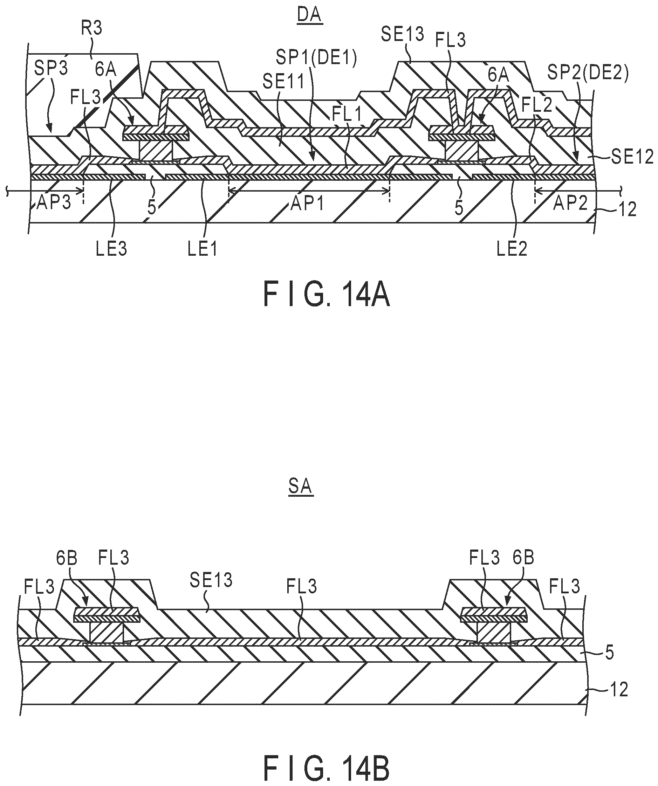

The display element DE3 is formed by a procedure similar to the procedures of the display elements DE1 and DE2. In other words, to form the display element DE3, first, as shown in FIG. 14A and FIG. 14B, the stacked film FL3 and the sealing layer SE13 are formed in the entire part of the display area DA and the surrounding area SA. The stacked film FL3 includes, as shown in FIG. 3, the organic layer OR3 which is in contact with the lower electrode LE3 through the pixel aperture AP3, the upper electrode UE3 which covers the organic layer OR3 and the cap layer CP3 which covers the upper electrode UE3. The organic layer OR3, the upper electrode UE3 and the cap layer CP3 are formed by vapor deposition. The sealing layer SE13 is formed by CVD.

Subsequently, the stacked film FL3 and the sealing layer SE13 are patterned. In this patterning, as shown in FIG. 14A, a resist R3 is provided on the sealing layer SE13. The resist R3 covers subpixel SP3 and part of the partition 6A around the subpixel. The resist R3 is not provided in the surrounding area SA.

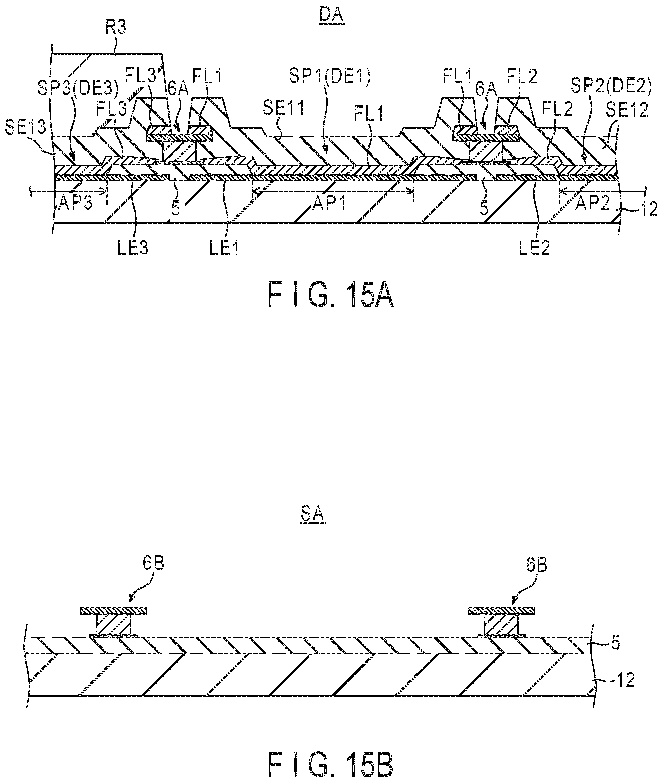

Subsequently, as shown in FIG. 15A and FIG. 15B, the portions of the stacked film FL3 and the sealing layer SE13 exposed from the resist R3 are removed by etching using the resist R3 as a mask. In other words, of the stacked film FL3 and the sealing layer SE13, the portions located above the lower electrode LE3 remain, and the other portions in the display area DA and the portions located in the surrounding area SA are removed. By this process, the display element DE3 is formed in subpixel SP3. For example, this etching includes wet etching and dry etching processes which are performed in order for the sealing layer SE13, the cap layer CP3, the upper electrode UE3 and the organic layer OR3. After this etching, the resist R3 is removed.

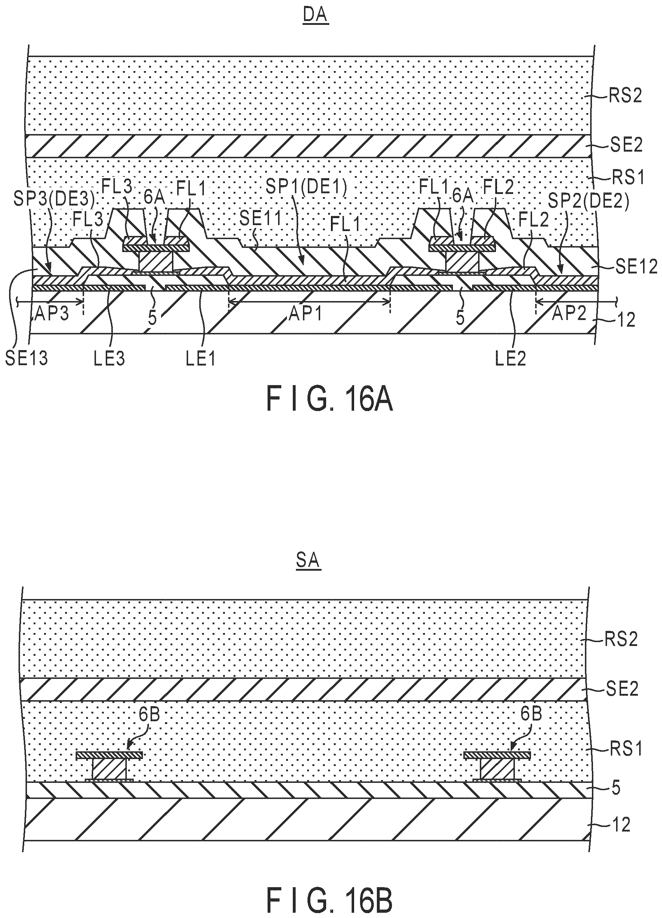

After the display elements DE1, DE2 and DE3 are formed, the resin layer RS1, the sealing layer SE2 and the resin layer RS2 are formed in order as shown in FIG. 16A and FIG. 16B. The resin layer RS1 directly covers the sealing layers SE11, SE12 and SE13 in the display area DA. The resin layer RS1 directly covers the rib layer 5 and the partition 6B in the surrounding area SA.

The resin layers RS1 and RS2 may be formed by, for example, an ink-jet method. The sealing layer SE2 can be formed by CVD. Before the resin layers RS1 and RS2 are cured, the resin layers RS1 and RS2 are dammed up by the dam portions DM1, DM2, DM3 and DM4 as described above.

The stacked films FL1, FL2 and FL3 which are formed by vapor deposition have weak adherence to the base. Therefore, there is a possibility that the stacked films FL1, FL2 and FL3 are peeled off from the base during the manufacturing process of the display device DSP. When this peeling expands, the stacked films FL1, FL2 and FL3 and the sealing layers SE11, SE12 and SE13 located thereon may be removed. Thus, they could cause the contamination of chambers etc., in the manufacturing line.

In this respect, in this embodiment, the stacked films FL1, FL2 and FL3 are divided by the partitions 6A and 6B having overhang shapes. Therefore, even if the stacked films FL1, FL2 and FL3 are peeled off, the peeled range does not easily expand. In addition, the stacked films FL1, FL2 and FL3 divided by the partitions 6A and 6B are pressed by the sealing layers SE11, SE12 and SE13 which are formed so as to dig into the lower sides of the upper portions 62 of the partitions 6A and 6B. Thus, the stacked film FL1, FL2 or FL3 is not easily removed.

However, in a case where the stacked film FL2 and the sealing layer SE12 are formed without eliminating the stacked film FL1 and the sealing layer 11 in the surrounding area SA, there is a possibility that the effect of preventing the removal by the partition 6B cannot be obtained. Specifically, the partition 6B is covered with the sealing layer SE11 which is relatively thick. Thus, the stacked film FL2 which is subsequently formed is not easily divided by the partition 6B. As a result, if the stacked film FL2 is peeled off, the peeled range may expand, and thus, the stacked film FL2 and the sealing layer SE12 are easily removed. This problem is also applied to a case where the stacked film FL3 and the sealing layer SE13 are formed without eliminating the stacked film FL2 and the sealing layer SE12.

To the contrary, in the embodiment, before the formation of the stacked film FL2 and the sealing layer SE12, the stacked film FL1 and the sealing layer SE11 are eliminated in the surrounding area SA. In addition, before the formation of the stacked film FL3 and the sealing layer SE13, the stacked film FL2 and the sealing layer SE12 are eliminated in the surrounding area SA. In this manner, the stacked films FL2 and FL3 are satisfactorily divided by the partition 6B. The removal of the stacked films FL2 and FL3 and the sealing layers SE12 and SE13 can be prevented.

As described above, the display device DSP and the manufacturing method thereof in the embodiment can improve the yield at the time of manufacturing the display device DSP. Various other desirable effects can be obtained from the embodiment.

### [Second Embodiment]

A second embodiment is explained. Regarding a display device DSP, configurations or manufacturing processes which are not referred to in the following explanation are the same as those of the first embodiment.

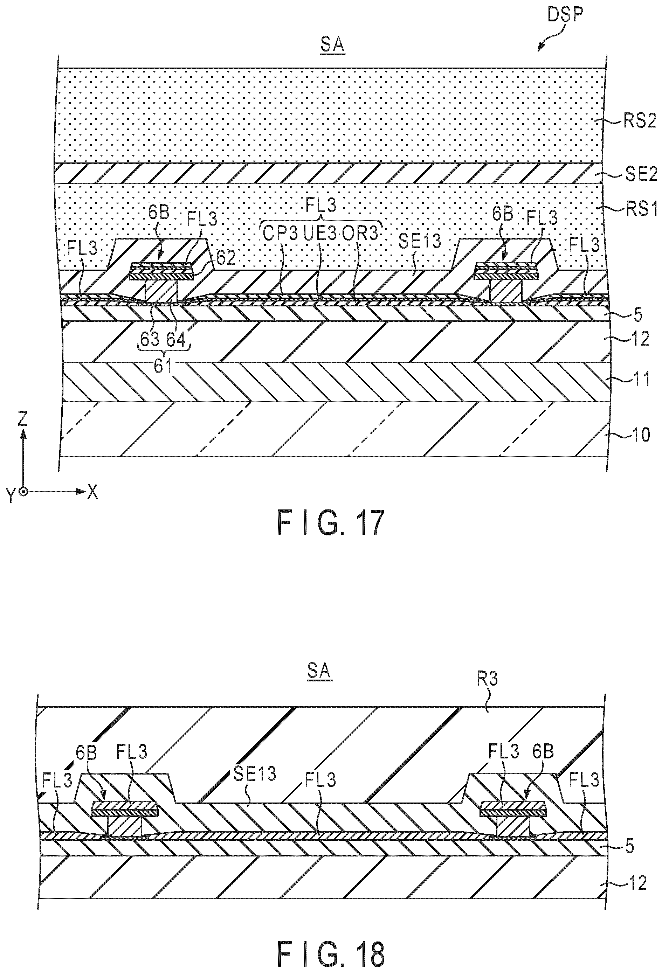

FIG. 17 is a schematic cross-sectional view of the surrounding area SA of the display device DSP according to the second embodiment. In this embodiment, a stacked film FL3 and a sealing layer SE13 are provided in the surrounding area SA.

The stacked film FL3 provided in the surrounding area SA is divided into a plurality of portions by a partition 6B. Theses portions are continuously covered with the sealing layer SE13. The sealing layer SE13 is covered with a resin layer RS1.

The stacked film FL3 and the sealing layer SE13 may be provided in the entire surrounding area SA or may be provided in part of the surrounding area SA.

For example, the stacked film FL3 and the sealing layer SE13 are provided in the area located between the display area DA and the dam portion DM1 in FIG. 5. It should be noted that the stacked film FL3 and the sealing layer SE13 may cover at least part of the dam portions DM1, DM2, DM3 and DM4.

Now, this specification explains the manufacturing method of the display device DSP according to this embodiment. The process of forming the partitions 6A and 6B and the process of forming display elements DE1 and DE2 are as explained using FIG. 8A to FIG. 13A and FIG. 8B to FIG. 13B in the first embodiment.

FIG. 18 to FIG. 20 are schematic cross-sectional views showing the manufacturing process of the display device DSP according to this embodiment. To form a display element DE3, the stacked film FL3 and the sealing layer SE13 are formed in the entire part of the display area DA and the surrounding area SA in a manner similar to that of the first embodiment. Further, the stacked film FL3 and the sealing layer SE13 are patterned using a resist R3 as a mask. At this time, the structure of the display area DA is as shown in FIG. 14A and FIG. 15A.

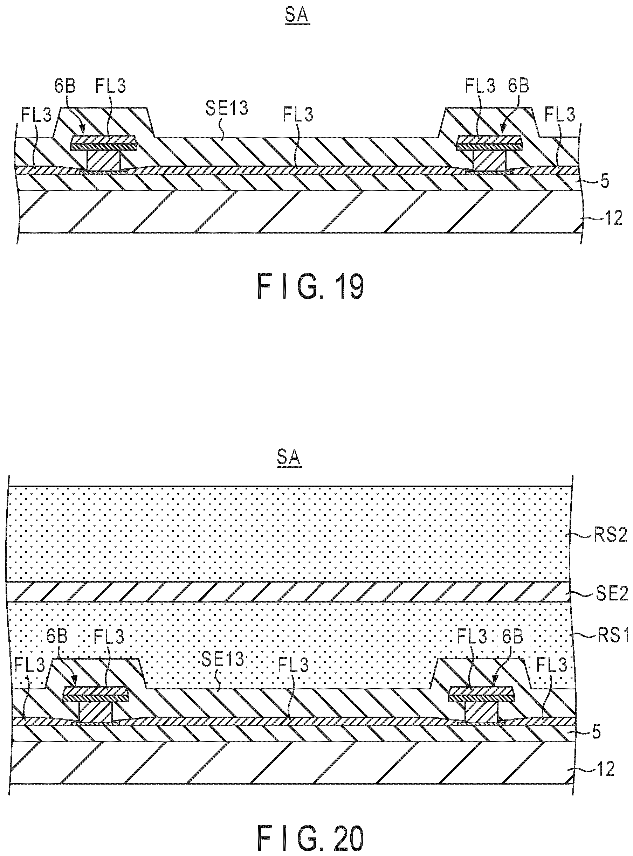

In the surrounding area SA, as shown in FIG. 18, the resist R3 is provided in the area where the stacked film FL3 and the sealing layer SE13 should remain. When etching is applied in this state, as shown in FIG. 19, the stacked film FL3 and the sealing layer SE13 remain in the surrounding area SA. Specifically, in this etching, of the stacked film FL3 and the sealing layer SE13, the portions located above the lower electrode LE3 and the portions located in the surrounding area SA remain, and the other portions in the display area DA are eliminated.

Subsequently, as shown in FIG. 20, a resin layer RS1, a sealing layer SE2 and a resin layer RS2 are formed in order. By this process, the structure of the surrounding area SA shown in FIG. 17 can be obtained.

In this embodiment, similarly, before the formation of a stacked film FL2 and a sealing layer SE12, a stacked film FL1 and a sealing layer SE11 are eliminated in the surrounding area SA. In addition, before the formation of the stacked film FL3 and the sealing layer SE13, the stacked film FL2 and the sealing layer SE12 are eliminated in the surrounding area SA. Thus, in a manner similar to that of the first embodiment, the removal of the stacked films FL2 and FL3 and the sealing layers SE12 and SE13 can be prevented.

In the display device DSP of the embodiment, the sealing layer SE13 is provided above an organic insulating layer 12 in the surrounding area SA. By this configuration, compared to the configuration of the first embodiment, the effect of preventing moisture incursion into the organic insulating layer 12 is improved.

The light emission performance of the organic layers OR1, OR2 and OR3 shown in FIG. 4 is more easily affected by the surface texture of the lower electrodes LE1, LE2 and LE3 which are bases as the wavelength of the emitted light is shorter. The surface texture of the lower electrodes LE1, LE2 and LE3 could be degraded when they are exposed to the etching of the stacked films FL1, FL2 and FL3 and the sealing layers SE11, SE12 and SE13. Therefore, it is preferable that the organic layers OR1, OR2 and OR3 should be formed earlier as the wavelength of the emitted light is shorter.

As described above, the organic layer OR1 emits blue light. The organic layer OR2 emits green light. The organic layer OR3 emits red light. The wavelength of blue light is shorter than that of green light. The wavelength of green light is shorter than that of red light. Therefore, in a case where, like the first embodiment and the second embodiment, the display element DE1 is formed firstly, and the display element DE2 is formed secondly, and the display element DE3 is formed lastly, the display device DSP which has a stable display quality and excellent reliability can be obtained.

In the display device DSP of this embodiment, as described above, the organic layer OR3 which emits light having a wavelength longer than the organic layers OR1 and OR2 is provided in at least part of the surrounding area SA. When subpixels SP1, SP2 and SP3 are provided as shown in the layout of FIG. 2, the organic layer OR3 provided in the pixel aperture AP3 which is smaller than the pixel apertures AP1 and AP2 is provided in at least part of the surrounding area SA.

### [Third Embodiment]

In the configurations of the first and second embodiments, the resin layer RS1, the sealing layer SE2 and the resin layer RS2 are stacked in the display area DA and the surrounding area SA. This embodiment exemplarily shows the configuration of a display device DSP in which a resin layer RS1 is not provided in at least a surrounding area SA. Regarding the display device DSP, configurations or manufacturing processes which are not referred to in the following explanation are the same as those of the first embodiment or the second embodiment.

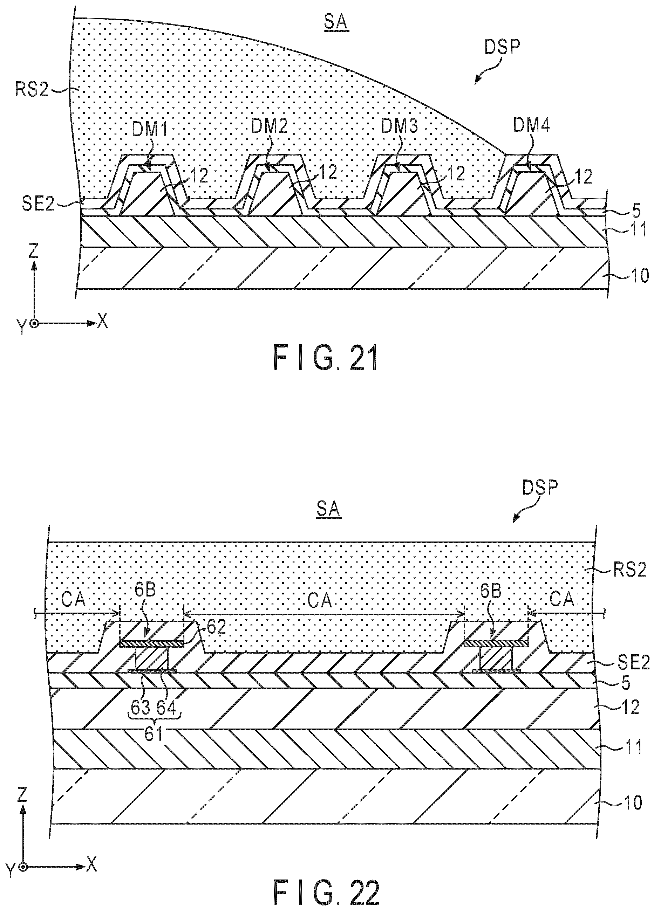

FIG. 21 and FIG. 22 are schematic cross-sectional views showing an example of the surrounding area SA of the display device DSP according to the third embodiment. FIG. 21 corresponds to a section taken along the VI-VI line of FIG. 5 in a manner similar to that of FIG. 6. FIG. 22 corresponds to a section taken along the VII-VII line of FIG. 5 in a manner similar to that of FIG. 7.

In FIG. 21 and FIG. 22, in a manner similar to that of the first embodiment, none of stacked films FL1, FL2 and FL3 and sealing layers SE11, SE12 and SE13 is provided in the surrounding area SA. Further, as described above, the resin layer RS1 is not provided in the surrounding area SA. By this configuration, in the example of FIG. 21, a sealing layer SE2 is entirely in contact with a rib layer 5 which covers dam portions DM1, DM2, DM3 and DM4.

In the example of FIG. 22, the sealing layer SE2 continuously covers a partition 6B and the rib layer 5. Specifically, the sealing layer SE2 is in contact with the bottom layer 63, stem layer 64 and upper portion 62 of the partition 6B and is also in contact with the rib layer 5 in a closed area CA.

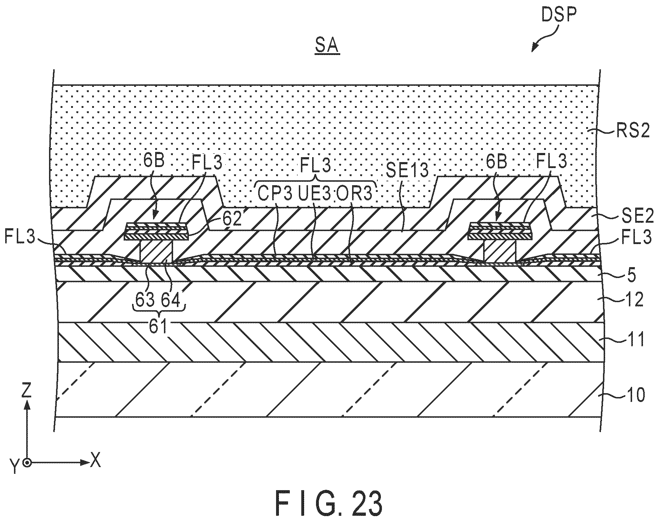

FIG. 23 is a schematic cross-sectional view showing another example of the surrounding area SA of the display device DSP according to the third embodiment. In FIG. 23, in a manner similar to that of the second embodiment (FIG. 17), the stacked film FL3 and the sealing layer SE13 are provided in the surrounding area SA. Further, the sealing layer SE2 is in contact with the sealing layer SE13.

Even in a case where the resin layer RS1 is not provided in the surrounding area SA like this embodiment, effects similar to those of the above embodiments can be obtained.

All of the display devices and manufacturing methods thereof that can be implemented by a person of ordinary skill in the art through arbitrary design changes to the display device and manufacturing method thereof disclosed above as each embodiment of the present invention come within the scope of the present invention as long as they are in keeping with the spirit of the present invention.

Various modification examples which may be conceived by a person of ordinary skill in the art in the scope of the idea of the present invention will also fall within the scope of the invention. For example, even if a person of ordinary skill in the art arbitrarily modifies the above embodiments by adding or deleting a structural element or changing the design of a structural element, or by adding or omitting a step or changing the condition of a step, all of the modifications fall within the scope of the present invention as long as they are in keeping with the spirit of the invention.

Further, other effects which may be obtained from the above embodiments and are self-explanatory from the descriptions of the specification or can be arbitrarily conceived by a person of ordinary skill in the art are considered as the effects of the present invention as a matter of course.

## Claims

1. A display device (DSP) **characterized by** comprising:
an organic insulating layer (12) provided in a display area (DA) which displays an image and a surrounding area (SA) around the display area (DA);
a lower electrode (LE1, LE2, LE3) provided above the organic insulating layer (12) in the display area (DA) ;
a rib layer (5) provided in the display area (DA) and the surrounding area (SA) and having a pixel aperture (AP1, AP2, AP3) which overlaps the lower electrode (LE1, LE2, LE3);
a first partition (6A) provided above the rib layer (5) in the display area (DA);
a second partition (6B) provided above the rib layer (5) in the surrounding area (SA);
an organic layer (OR1, OR2, OR3) which is in contact with the lower electrode (LE1, LE2, LE3) through the pixel aperture (AP1, AP2, AP3) and emits light based on application of voltage;
an upper electrode (UE1, UE2, UE3) which covers the organic layer (OR1, OR2, OR3) and is in contact with the first partition (6A);
a sealing layer (SE11, SE12, SE13) which covers a stacked film (FL1, FL2, FL3) including the organic layer (OR1, OR2, OR3) and the upper electrode (UE1, UE2, UE3); and
a resin layer (RS1) which is provided in the display area (DA) and the surrounding area (SA) and covers the sealing layer (SE11, SE12, SE13), wherein
each of the first partition (6A) and the second partition (6B) includes a lower portion (61) provided above the rib layer (5) and an upper portion (62) having an end portion which protrudes from a side surface of the lower portion (61), and
the resin layer (RS1) directly covers the rib layer (5) and the second partition (6B) in at least part of the surrounding area (SA).

2. The display device (DSP) of claim 1, further comprising a dam portion (DM1, DM2, DM3, DM4, DM5) which is formed of the organic insulating layer (12) located in the surrounding area (SA) and surrounds the display area (DA), wherein
the resin layer (RS1) directly covers the rib layer (5) and the second partition (6B) in an area located between the display area (DA) and the dam portion (DM1, DM2, DM3, DM4, DM5).

3. The display device (DSP) of claim 1, wherein
at least part of the second partition (6B) has a grating shape.

4. The display device (DSP) of claim 1, wherein
the lower portion (61) of each of the first partition (6A) and the second partition (6B) includes a stem layer (64) and a bottom layer (63) located between the stem layer (64) and the rib layer (5), and
an end portion of the bottom layer (63) protrudes from a side surface of the stem layer (64).

5. The display device (DSP) of claim 1, wherein
the stacked film (FL1, FL2, FL3) further includes an optical adjustment layer (CP1, CP2, CP3) which covers the upper electrode (UE1, UE2, UE3).

6. A display device (DSP) **characterized by** comprising:
an organic insulating layer (12) provided in a display area (DA) which displays an image and a surrounding area (SA) around the display area (DA);
a first lower electrode (LE1), a second lower electrode (LE2) and a third lower electrode (LE3) provided above the organic insulating layer (12) in the display area (DA);
a rib layer (5) provided in the display area (DA) and the surrounding area (SA) and having a first pixel aperture (AP1), a second pixel aperture (AP2) and a third pixel aperture (AP3) overlapping the first lower electrode (LE1), the second lower electrode (LE2) and the third lower electrode (AP3), respectively;
a first partition (6A) provided above the rib layer (5) in the display area (DA);
a second partition (6B) provided above the rib layer (5) in the surrounding area (SA);
a first organic layer (OR1), a second organic layer (OR2) and a third organic layer (OR3) which are in contact with the first lower electrode (LE1), the second lower electrode (LE2) and the third lower electrode (LE3) through the first pixel aperture (AP1), the second pixel aperture (AP2) and the third pixel aperture (AP3), respectively, and emit light based on application of voltage;
a first upper electrode (UE1), a second upper electrode (UE2) and a third upper electrode (UE3) which cover the first organic layer (OR1), the second organic layer (OR2) and the third organic layer (OR3), respectively, and are in contact with the first partition (6A);
a first sealing layer (SE11) which covers a first stacked film (FL1) including the first organic layer (OR1) and the first upper electrode (UE1);
a second sealing layer (SE12) which covers a second stacked film (FL2) including the second organic layer (OR2) and the second upper electrode (UE2); and
a third sealing layer (SE13) which covers a third stacked film (FL3) including the third organic layer (OR3) and the third upper electrode (UE3), wherein
each of the first partition (6A) and the second partition (6B) includes a lower portion (61) provided above the rib layer (5) and an upper portion (62) having an end portion which protrudes from a side surface of the lower portion (61),
a wavelength of light emitted from the third organic layer (OR3) is longer than wavelengths of light emitted from the first organic layer (OR1) and the second organic layer (OR2), and
the third stacked film (FL3) and the third sealing layer (SE13) are provided in at least part of the surrounding area (SA).

7. The display device (DSP) of claim 6, wherein the third pixel aperture (AP3) is smaller than at least one of the first pixel aperture (AP1) and the second pixel aperture (AP2).

8. The display device (DSP) of claim 6, wherein
the first organic layer (OR1) emits blue light,
the second organic layer (OR2) emits green light, and
the third organic layer (OR3) emits red light.

9. The display device (DSP) of claim 6, further comprising a resin layer (RS1) which covers the first sealing layer (SE11), the second sealing layer (SE12) and the third sealing layer (SE13) in the display area (DA) and covers the third sealing layer (SE13) in the surrounding area (SA).

10. The display device (DSP) of claim 6, wherein
at least part of the second partition (6B) has a grating shape.

11. The display device (DSP) of claim 6, wherein
the third stacked film (FL3) located in the surrounding area (SA) is divided by the second partition (6B).

12. The display device (DSP) of claim 11, wherein
the third sealing layer (SE13) located in the surrounding area (SA) continuously covers the third stacked film (OR3) divided by the second partition (6B) .

13. The display device (DSP) of claim 6, wherein
the lower portion (61) of each of the first partition (6A) and the second partition (6B) includes a stem layer (64) and a bottom layer (63) located between the stem layer (64) and the rib layer (5), and
an end portion of the bottom layer (63) protrudes from a side surface of the stem layer (64).

14. A manufacturing method of a display device (DSP), **characterized by** including:
forming an organic insulating layer (12) in a display area (DA) which displays an image and a surrounding area (SA) around the display area (DA);
forming a first lower electrode (LE1), a second lower electrode (LE2) and a third lower electrode (LE3) above the organic insulating layer (12) in the display area (DA);
forming a rib layer (5) which covers the first lower electrode (LE1), the second lower electrode (LE2) and the third lower electrode (LE3) in the display area (DA) and the surrounding area (SA);
forming a first partition (6A) including a lower portion (61) provided above the rib layer (5) and an upper portion (62) having an end portion which protrudes from a side surface of the lower portion (61) in the display area (DA);
forming a second partition (6B) including the lower portion (61) and the upper portion (62) in the surrounding area (SA);
forming a first pixel aperture (AP1), a second pixel aperture (AP2) and a third pixel aperture (AP3) which overlap the first lower electrode (LE1), the second lower electrode (LE2) and the third lower electrode (LE3), respectively, in the rib layer (5) before or after forming the first partition (6A) and the second partition (6B);
forming a first stacked film (FL1) including a first organic layer (OR1) which emits light based on application of voltage and a first upper electrode (UE1) which is in contact with the lower portion (61) in the display area (DA) and the surrounding area (SA);
forming a first sealing layer (SE11) which covers the first stacked film (FL1);
of the first stacked film (FL1) and the first sealing layer (SE11), leaving portions located above the first lower electrode (LE1), and eliminating other portions in the display area (DA) and portions located in the surrounding area (SA);
forming a second stacked film (FL2) including a second organic layer (OR2) which emits light based on application of voltage and a second upper electrode (UE2) which is in contact with the lower portion (61) in the display area (DA) and the surrounding area (SA);
forming a second sealing layer (SE12) which covers the second stacked film (FL2);
of the second stacked film (FL2) and the second sealing layer (SE12), leaving portions located above the second lower electrode (LE2), and eliminating other portions in the display area (DA) and portions located in the surrounding area (SA);
forming a third stacked film (OR3) including a third organic layer (OR3) which emits light based on application of voltage and a third upper electrode (UE3) which is in contact with the lower portion (61) in the display area (DA) and the surrounding area (SA); and
forming a third sealing layer (SE13) which covers the third stacked film (OR3).

15. The manufacturing method of claim 14, further including
of the third stacked film (FL3) and the third sealing layer (SE13), leaving portions located above the third lower electrode (LE3), and eliminating other portions in the display area (DA) and portions located in the surrounding area (SA).

16. The manufacturing method of claim 15, further including
forming a resin layer (RS1) which covers the first sealing layer (SE11), the second sealing layer (SE12) and the third sealing layer (SE13) in the display area (DA), and directly covers the rib layer (5) and the second partition (6B) in at least part of the surrounding area (SA).

17. The manufacturing method of claim 14, further including
of the third stacked film (FL3) and the third sealing layer (SE13), leaving portions located above the third lower electrode (LE3) and portions located in the surrounding area (SA), and eliminating other portions in the display area (DA).

18. The manufacturing method of claim 17, wherein
a wavelength of light emitted from the third organic layer (OR3) is longer than wavelengths of light emitted from the first organic layer (OR1) and the second organic layer (OR2).

19. The manufacturing method of claim 17, wherein
the third pixel aperture (AP3) is smaller than at least one of the first pixel aperture (AP1) and the second pixel aperture (AP2).

20. The manufacturing method of claim 17, wherein
the first organic layer (OR1) emits blue light,
the second organic layer (OR2) emits green light, and
the third organic layer (OR3) emits red light.
